(19) Europäisches Patentamt
European Patent Office
Office européen des brevets

(11) Publication number: **0 408 227 A1**

(12) # EUROPEAN PATENT APPLICATION

(21) Application number: 90307201.5

(22) Date of filing: 02.07.90

(51) Int. Cl.5: G03F 7/029, G03F 7/038, G03F 7/039, G03F 7/075, C08F 4/52

(30) Priority: 30.06.89 US 374505
04.10.89 US 416883

(43) Date of publication of application:
16.01.91 Bulletin 91/03

(84) Designated Contracting States:
CH DE FR GB LI

(71) Applicant: THE MEAD CORPORATION
2000 Courthouse Plaza NE
Dayton Ohio 45463(US)

(72) Inventor: Liang, Rong-Chang
386 Lightbeam Drive
Centerville, Ohio 45458(US)
Inventor: Davis, Paul
9904 Redbarn Trail
Centerville, Ohio 45459(US)
Inventor: Shanklin, Michael Samuel
2541 Steeplechase No.1A
Miamisburg, Ohio 45342(US)
Inventor: Tsai, Yi-Guan
465 Wellington Way
Springboro, Ohio 45066(US)

(74) Representative: Deans, Michael John Percy et al
Lloyd Wise, Tregear & CO. Norman House
105-109 Strandand
London WC2R OAE(GB)

(54) **Photohardenable or photosoftenable compositions.**

(57) A photohardenable or photosoftenable composition comprises a cationic polymerizable or depolymerizable compound and a photoinitiator. The photoinitiator includes an anionic dye reactive counter ion complex and an onium salt and is capable of cationically polymerizing or depolymerizing the polymerizable or depolymerizable compound upon exposure to visible light.

EP 0 408 227 A1

## PHOTOHARDENABLE OR PHOTOSOFTENABLE COMPOSITIONS

The present invention relates to novel photosensitive compositions and to photosensitive materials employing them. More particularly, it relates to compositions which are photohardenable or photosoftenable.

US Patent Nos: 4 399 209 and 4 440 846 to The Mead Corporation describe imaging materials and imaging processes in which images are formed through exposure-controlled release of an image-forming agent from a microcapsule containing a photohardenable or photosoftenable composition. The imaging material is exposed image-wise to actinic radiation and the microcapsules are subjected to a uniform rupturing force. Typically, the image-forming agent is a colour precursor which is released image-wise from the microcapsules to a developer sheet whereupon it reacts with a developer to form a visible image.

The photohardenable composition according to US Patent Nos: 4 399 209 and 4 440 846 typically comprises an ethylenically unsaturated monomer which undergoes polymerization by free radical addition polymerization. An example of such a monomer is trimethylolpropane triacrylate. In addition to the monomer, the photosensitive composition also includes a photoinitiator for generating free radicals to initiate polymerization of the monomer. U.S. Patent Nos. 4,772,530 and 4,772,541 disclose a particularly preferred class of photoinitiators which generate free radicals upon exposure to visible light. These photoinitiators are ionic dye reactive counter ion complexes.

Despite the success of the above-described photographic system, efforts are continuing to improve the properties associated with the system. For example, it would be desirable to increase the number of materials which may be used as the monomer. For example, to date, the monomers utilized have generally been limited to acrylates and methacrylates. It would be desirable to utilize other monomeric materials such as vinyl ethers and epoxy compounds as they are less toxic.

A further goal is to improve the film speed of the photohardenable material. It is hypothesized that the ability to obtain a very fast film speed product is limited for free radical initiated photopolymerization as oxygen tends to scavenge free radicals and because the ability of the photohardenable material to rapidly increase its molecular weight is controlled by unimolecular and bimolecular termination reactions.

An alternative method of initiating polymerization of polymerizable materials is cationic photoinitiation. For example, U.S. Patent No. 4,264,703 assigned to General Electric discloses cationic polymeriation of a variety of organic materials such as vinyl monomers, prepolymers, cyclic ethers, cyclic esters and cyclic organosiloxanes. Polymerization is effected by utilization of an initiator which includes a cationic aromatic halonium salt in combination with an anionic metal salt. A particular class of halonium salts are diaryliodonium salts. These salts are capable of cationically initiating polymerization of monomeric materials upon exposure to ultraviolet light. These salts are further described in greater detail in U.S. Patent No. 4,264,703 and in Crivello and Lam, "Diaryliodonium Salts. A New Class of Photoinitiators for Cationic Polymerization", Macromolecules , Vol. 10 No. 6, pp. 1307-1315 (1977). An alternative class of cationic initiators are triarylsulfonium salts. These are disclosed in Crivello and Lam, "Photoinitiated Cationic Polymerization with Triarylsulfonium Salts", Journal of Polymer Science , Vol. 17, pp. 977-999 (1979).

The practical application of the above onium salts as cationic photoinitiators has been limited by the low absorptivity at wavelengths above 300 nanometers. However, it has been discovered that the spectral response of onium salts may be extended into the near ultraviolet and visible wavelengths by energy transfer and electron transfer/redox sensitization.

An extensive review of this is described in Crivello, Adv. in Polymer Sci., 62 , 1 (1984). Although the use of certain photosensitizer-onium salt combinations may cause energy transfer to be extended into the visible spectrum it is extremely inefficient and hence of little practical utility for cationic photopolymerzation.

Redox sensitization can occur by two distinct mechanisms. The first mechanism is a direct electron transfer which competes with back electron transfer to release an acidic or cationic species. The other is indirect electron transfer wherein a free radical is photogenerated and subsequently undergoes electron transfer to the onium salt to release an acid or cationic species. Examples of the former mechanism have been described in U.S. Patent No. 4,026,705 assigned to General Electric and in Crivello and Lam, "Dye-sensitized Photoinitiated Cationic Polymerization", Journal of Polymer Science , Vol. 16, Polym. Chem. Ed., pp. 2441-2451 (1978) and ibid, 17 , p. 1059 (1979). As disclosed in these references an organic dye sensitizes the decomposition of onium salts, particularly diaryliodonium salts, upon exposure to radiation. Examples of dyes which are capable of photoexcitation as disclosed in the references include acridine and benzoflavin cationic dyes, benzophenone type basic dyes and perylene type neutral dyes. The quantum efficiency of the direct electron transfer is relatively low, and the spectral sensitivity is generally limited to wavelengths less than 550 nm.

Examples of the indirect electron transfer mechanism have been described in A. Ledwith, Polymer, 19 ,

pp. 1217, 1219 (1978); Goethels, ed., "Cationic Polymerization and Related Processes", Academic Press, p. 275 (1984); Crivello and Lee, Macromolecules, 14 , 1141 (1981); Yagci et al., Makromel. Chem., Rapid Commun., 8 , p. 209 (1987); and Maklomol. Chem. Symp. , 13/14 , p. 161 (1988). Quantum yields greater than unity have been reported for the indirect electron transfer process. The photogenerated radicals from the sensitizer induce chain decomposition of onium salts and generate high yields of cations.

Few of the above references describe or suggest the use of visible light free radical photoinitiators as the radical promoters for onium salt decomposition at wavelengths greater than 500 nm, and none of the references disclose or suggest the use of photoinitiators such as cationic dye-borate anion complexes which can extend initiation throughout the entire visible spectrum and into the near infrared spectrum.

The above-described cationically polymerized materials have been used as moulding and extrusion resins, adhesives, caulks, coatings, printing inks, impregnated tapes, insulation, sealants, blood plasma extenders, lubricants and the like.

As will become apparent from the detailed description hereinbelow, we have now developed compositions which are photohardenable or photosoftenable in nature formed by cationic polymerization or depolymerization. Our cationically photohardenable and photosoftenable compositions contain a photoinitiator which includes an ionic dye reactive counter ion complex and an onium salt. By utilizing this specific photoinitiator, the resultant composition can be polymerized or depolymerized by cationic initiation upon exposure to radiation and particularly radiation extending throughout the entire visible spectrum.

It has been known in the art to utilize cationic photoinitiators which release cations to initiate polymerization of a photopolymerizable material by exposure to ultraviolet light. As will be seen from the description below, the presence of the ionic dye reactive counter ion complex in our photoinitiator enables the sensitivity of the cationic initiator to be extended to greater than 400 nm and through the visible wavelength and near infrared bands. While not wishing to be bound by any specific theory, we hypothesize that upon exposure of the ionic dye reactive counter ion complex photoinitiator to visible light, the complex releases a free radical. The free radical then transfers an electron to the onium salt and releases a cation. Once the cation has been released, it then polymerizes or depolymerizes the polymerizable or depolymerizable material. We refer to the above hypothesized mechanism as the indirect electron transfer by a radical promoter mechanism.

According to a first aspect of the present invention, we provide a photohardenable or photosoftenable composition characterised in comprising: a cationically polymerizable or depolymerizable compound, and a photoinitiator including an ionic dye reactive counter ion complex and an onium salt and being capable of initiating cationic polymerization or depolymerization of said polymerizable or depolymerizable compound upon exposure to actinic radiation.

In a second and alternative aspect thereof, the invention provides the use of a photoinitiator including an ionic dye reactive counter ion complex and an onium salt to initiate cationic polymerization or depolymerization upon exposure to actinic radiation of a cationically polymerizable or depolymerizable compound.

The invention provides, in a third and further alternative aspect thereof, a photoinitiator capable upon exposure to actinic radiation of producing cations to initiate cationic polymerization or depolymerization of a cationically polymerizable or depolymerizable compound, said photoinitiator comprising an ionic dye reactive counter ion complex and an ionium salt.

One of the particular advantages of the above initiators is the ability to select from a large number of ionic dye reactive counter ion complexes which absorb radiation at substantially different wavelengths to release free radicals. Thus, by selecting a complex which absorbs at 400 nm or greater, the sensitivity of the photosensitive material can be extended well into the visible range.

Our photoinitiator compositions are believed to be useful in any photohardenable or photosoftenable composition which is polymerizable or depolymerizable by cationic polymerization, and are particularly useful as photoinitiators for imaging systems, particularly microencapsulated imaging systems. By utilizing a suitable onium salt capable of generating cations, cationically polymerizable materials such as epoxy materials, vinyl ethers and tetrahydrofuran may be polymerized with the aid of ionic dye reactive counter ion visible light sensitive free radical photoinitiators. Further, by utilizing cationic photoinitiation, several depolymerizable materials, such as polyesters, polycarbonates and polyaldehydes which are otherwise unaffected by free radical initiators, may be depolymerized by utilization of the cationic photoinitiator compositions. In a particular embodiment, a dual initiator system is provided which utilizes both cationic and free radical initiation mechanisms. Use of a dual initiator system enables rapid cure of stable monomeric materials and provides a wide latitude in the selection of polymer structure and properties.

A particularly preferred use of our compositions is as photoimaging compositions. By selecting ionic dye counter ion complexes which absorb at distinctly different wavelength bands, a full colour photosensitive material in which the cationically photohardenable or photosoftenable compositions are microencapsulated is provided. In these materials, a layer including three sets of microcapsules having distinct sensitivity characteristics is provided on a support. Each set of microcapsules respectively contains a cyan, magenta, or yellow image-forming agent. Photoinitiators can be designed for use in the cyan-, magenta-, and yellow-forming capsules which are respectively sensitive to red, green and blue light, thereby providing a panchromatic imaging system.

A further advantage associated with the present photosensitive compositions is that they may achieve faster film speeds as a result of being less dependent on the absence of oxygen for photoinitiation. For example, in prior art free radical type photoinitiators, if oxygen is present during any stage of photopolymerization or depolymerization, the polymerization or depolymerization reactions can terminate as a result of the quenching of free radicals by oxygen. By stark comparison, in the present system, oxygen is only a concern at the inception of initiation, and even then, the excited state lifetimes of the dyes are so short that quenching is extremely unlikely to occur at all. Once a cation has been generated, polymerization proceeds independent of the presence of oxygen. Further, cationic initiation, as opposed to free radical initiation, is self-effectuating in the sense that when a single cation has been generated, polymerization or depolymerization will automatically continue until termination by a nucleophile. In fact, once a suitable free radical has been generated by the ionic dye reactive counter ion complex, it will react with the onium salt to liberate a cation and a new radical. The quantum efficiency of photopolymerization can be greater than one since a radical is regenerated arid this radical can react again either directly or indirectly with the onium salt to generate additional cations. As a result of the increased efficiency of the cationic initiator, faster film speeds may be achieved. The high quantum efficiency of the initiation process and the elimination of termination mechanisms, for example in the case of free radical photoinitiation radical-radical combination, provides the capability of producing a digital or near digital imaging system, even when using high intensity exposures.

It is particularly preferred that the ionic dye reactive counter ion complex take the form of an anionic ionic dye reactive counter ion complex, and that the onium salt take the form of either a diaryliodonium salt, a triarylsulfonium salt or a phenacylsulfonium salt. The cationically polymerizable compound typically takes the form of an epoxy compound; a vinyl monomer, a vinyl prepolymer, a vinyl ether, a vinyl ether prepolymer, a cyclic ether, a cyclic ester, a cyclic sulfide, cyclic organosiloxanes, a cyclic acetal, and the like. The cationically depolymerizable compounds typically take the form of a hindered polycarbonate, a hindered polyester, a poly(allylic ester), a polyaldehyde, a polyphthaldehyde, and the like.

The invention also extends to a photosensitive material comprising a support having a layer of the above-defined cationically photohardenable or photosoftenable composition. It is particularly preferred that the composition contain an image-forming agent and that the composition be maintained as an internal phase which is surrounded by microcapsule walls if the composition contains a cationically polymerizable monomer. If the composition contains a cationically depolymerizable compound, the compound is preferably at the periphery of a coloured microparticle or a microparticle containing developable dye precursors. It is also preferred that the photosensitive material be used in an imaging system whereupon it image-wise hardens or softens as a result of being exposed to visible light.

The photosensitive material is particularly useful in forming full-colour images. When forming full-colour images, the photosensitive material preferably comprises a support having coated thereon a layer of a photohardenable or photosoftenable composition, the composition including a first set of microcapsules or microparticles having a cyan image-forming agent associated therewith, a second set of microcapsules or microparticles having a magenta image-forming agent associated therewith, and a third set of microcapsules or microparticles having a yellow image-forming agent associated therewith, at least one of the three sets including the above-defined photohardenable or photosoftenable composition.

The invention will be better understood from the following description by way of example only of preferred embodiments.

The disclosures of US Patents Nos: 4 399 209, 4 440 846, 4 772 530 and 4 772 541 are incorporated herein by reference for additional detail which may be useful in putting the present invention into effect.

The present compositions include a cationically polymerizable or depolymerizable compound and a photoinitiator. The photoinitiator is capable of cationically polymerizing or depolymerizing the compound upon exposure to radiation, particularly visible light, and includes an ionic dye reactive counter ion complex and an onium salt. For some applications, the photoinitiator composition may include both free radical and cationic polymerization components to improve cure speed and performance.

Some of the applications in which examples of our compositions can be used are, for example, inks, adhesives, protective, decorative and insulating coatings, glass lamination, magnetic recording compositions, potting compounds, sealants, photoresists, wire insulation, can linings, textile coatings, laminates,

impregnated tapes, printing plates, imaging materials and the like. In a preferred embodiment, the compositions are used as imaging materials.

A number of compounds are capable of cationic polymerization or depolymerization. Examples of polymerizable compounds include epoxy compounds, vinyl or allyl monomers, vinyl or allylic prepolymers, vinyl ethers, vinyl ether functional prepolymers, cyclic ethers, cyclic esters, cyclic sulfides, melamine formaldehyde, phenolic formaldehyde, cyclic organosiloxanes, lactams and lactones, cyclic acetals and epoxy functional silicone oligomers.

Examples of cationically polymerizable epoxy compounds include any monomeric, dimeric or oligomeric or polymeric epoxy material containing one or a plurality of epoxy functional groups. For example, those resins which result from the reaction of bisphenol-A (4,4′-isopropylidenediphenol) and epichlorohydrin, or from the reaction of low molecular weight phenol-formaldehyde resins (Novolak resins) with epichlorohydrin, can be used alone or in combination with an epoxy containing compound as a reactive diluent. Such diluents as phenyl glycidyl ether, 4-vinylcyclohexene dioxide, limonene dioxide, 1,2-cyclohexene oxide, glycidyl acrylate, glycidyl methacrylate, styrene oxide, allyl glycidyl ether, etc., may be added as viscosity modifying agents.

In addition, the range of these compounds can be extended to include polymeric materials containing terminal or pendant epoxy groups. Examples of these compounds are vinyl copolymers containing glycidyl acrylate or methacrylate as one of the comonomers. Other classes of epoxy containing polymers amenable to cure are epoxy-siloxane resins, epoxy-polyurethanes and epoxy-polyesters. Such polymers usually have epoxy functional groups at the ends of their chains. Epoxy-siloxane resins and the method for making them are more particularly shown by E. P. Plueddemann and G. Fanger, J. Am. Chem. Soc. 81 632-5 (1959), and in Crivello et al., Proceeding ACS, PMSE, 60 , 217 (1989). As described in the literature, epoxy resins can also be modified in a number of standard ways such as reactions with amines, carboxylic acids, thiols, phenols, alcohols, etc., as shown in U.S. Patent Nos. 2,935,488; 3,235,620; 3,369,055; 3,379,653; 3,398,211; 3,403,199; 3,563,850; 3,567,797; 3,677,995, etc. Further examples of epoxy resins which can be used are shown in the Encyclopedia of Polymer Science and Technology, Vol. 6, 1967, Interscience Publishers, New York, pp 209-271.

Examples of vinyl or allyl organic monomers which can be used in the practice of the invention for example, styrene, vinyl acetamide, α-methyl styrene, isobutyl vinyl ether, n-octyl vinylether, acrolein, 1,1-diphenylethylene, R β-pinene; vinyl arenes such as 4-vinyl biphenyl, 1-vinyl pyrene, 2-vinyl fluorene, acenapthylene, 1 and 2-vinyl napthylene; 9-vinyl carbazole, vinyl pyrrolidone, 3-methyl-1-butene; vinyl cycloaliphatics such as vinylcyclohexane, vinylcyclopropane, 1-phenyvinylcyclopropane; dienes such as isobutylene, isoprene, butadiene, 1,4-pentadiene, etc.

Some of the vinyl organic prepolymers which can be used are, for example, $CH_2=CH\text{-}O\text{-}(CH_2O)_n\text{-}CH=CH_2$, where n is a positive integer having a value up to about 1000 or higher; multi-functional vinylethers, such as 1,2,3-propane trivinyl ether, trimethylolpropane trivinyl ether, polyethyleneglycol divinylether (PEGDVE), triethyleneglycol divinyl ether (TEGDVE), vinyl ether-polyurethane, vinyl ether-epoxy, vinyl ether-polyester, vinyl ether-polyether and other vinyl ether prepolymers such as 1,4-cyclohexane dimethanol-divinylether, commercially available from GAF and others, and low molecular weight polybutadiene having a viscosity of from 200 to 10,000 centipoises at 25 °C, etc.

A further category of the organic materials which can be used are cyclic ethers which are convertible to thermoplastics. Included by such cyclic ethers are, for example, oxetanes such as 3,3-bis-chloromethyloxetane alkoxyoxetanes as shown by U.S. Pat. No. 3,673,216; oxolanes such as tetrahydrofuran, oxepanes, oxygen containing spiro compounds, trioxane, dioxolane, etc.

In addition to cyclic ethers, there are also included cyclic esters such as -lactones, for example, propiolactone, cyclic amines, such as 1,3,3-trimethylazetidine and cyclic organosiloxanes, for example,

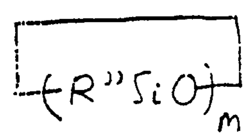

where R″ can be the same or different monovalent organic radicals such as methyl or phenyl and m is an integer equal to 3 to 8 inclusive. Examples of cyclic organosiloxanes include hexamethyl trisiloxane, octamethyl tetrasiloxane, etc. Cyclic acetals may also be used as the cationic polymerizable material.

Examples of epoxy functional silicone oligomers are commercially available from General Electric and are described in ACS PMSE Proceeding 1989, Vol. 60, pp. 217, 222.

Because the photoinitiator generates both free radicals and cations, it is possible to utilize a combination of free radical polymerizable and cationic polymerizable monomers. Examples of free radical polymerizable monomers include both monomers having one or more ethylenically unsaturated groups, such as vinyl or allyl groups, and polymers having terminal or pendant ethylenic unsaturation. Such compounds are well known in the art and include acrylic and methacrylic esters of polyhydric alcohols such as trimethylolpropane, pentaerythritol, and the like; and acrylate or methacrylate terminated epoxy resins, acrylate or methacrylate terminated polyesters, etc. Representative examples include ethylene glycol diacrylate, ethylene glycol dimethacrylate, trimethylolpropane triacrylate (TMPTA), pentaerythritol tetraacrylate, pentaerythritol tetramethacrylate, dipentaerythritol hydroxypentacrylate (DPHPA), hexanediol-1, 6-dimethacrylate, and diethyleneglycol dimethacrylate. For example, it is contemplated that a mixture of styrene or an acrylate and a vinyl ether or epoxy could be used as a starting material.

Examples of other materials which are both cationically and free radically cured include glycidyl methacrylates, epoxy acrylates, acrylated melamine formaldehyde and epoxidized siloxanes. The simultaneous utilization of a cationically and free radical curable system enables rapid curing to be accomplished and provides a wide latitude in the design of product performance. For example, when a solution of acrylate and epoxy acrylate is used as the dual curable composition, film properties ranging from flexible to rigid can be produced and desired adhesive characteristics can be produced by selection of designed ratios of functional groups. The epoxy functionality provides high temperature resistance, excellent adhesion and reduced oxygen sensitivity whereas the acrylate functionality provides rapid curing speed, excellent weatherability, flexibility and desirable viscosity. Other examples of dual curable systems will be envisioned and appreciated by those skilled in the art.

Representative examples of cationically photodepolymerizable materials useful in the present invention are described in U.S. Patents 4,108,839; 3,984,253; 3,917,483; 3,915,704 and 3,127,811. These materials are polyaldehydes, but other depolymerizable materials such as polycarbonates as disclosed by Crivello, "Applications of Photoinitiated Cationic Polymerization to the Development of New Photoresists," Polymers in Electronics , ACS 242 , p. 3 (1984) and Frechet et al., J. Imaging Science , 30 (2), p. 59 (1986); polyethers as disclosed by Goethals, E.J., "The Formation of Cyclic Oligomers in the Cationic Polymerization of Heterocyclics," Adv. Poly. Sci. , Vol. 23, p. 103 may be selected.

Of the aforementioned depolymerizable materials, those which hold the most potential are those which are acid degradable polymers. Included within this class of photodepolymerizable systems are compositions of acid degradable polyaldehydes including polyformals, polyphthaldehyde, allylic and hindered polyesters, polycarbonates including hindered and allylic polycarbonates, polysiloxanes and polyethers.

Another useful polymer is one which is crosslinked by an acid cleavable linking group. Exposure generates an acid as above which cleaves the linking group. Still another class of useful polymers are copolymers having acid degradable units or blocks in the polymer backbone.

The depolymerizable polyaldehydes which are useful in practice of the present invention include poly-(aromatic 1,2-dialdehydes), poly(aliphatic monoaldehydes), and copolymers thereof. Polyaldehydes may be end-capped with a group which stabilizes the polymer to depolymerization to provide thermal stability. The end-capping group may be one which is acid cleavable, such as an ester or an ether group, and separates from the polymer in the presence of a photogenerated acid. Alternatively, the polymer may be sufficiently stable to be processable in the microparticle without end-capping. Polycarbonates which are potentially useful in practice of the present invention are described in the aforementioned papers of Crivello and Frechet. One useful polycarbonate is formed from the reaction of 2,5-dimethyl-2,5-hexanediol and 4,4-isopropyllidenediphenol. Other polycarbonates which are depolymerizable include hydroxymethylated polycarbonates, tertiary allylic polycarbonates (see C.G. Wilson, J. Electrochem. Soc. , 133 , 181 (1986) , and Frechet, Proceedings, SPE Phatopolymer Conference, p. 1 (1985)).

Our present compositions additionally include a cationic photoinitiator which comprises anionic dye reactive counter ion complex and an onium salt.

Cationic dye-borate anion complexes are known in the art and comprise one type of useful ionic dye reactive counter ion complex. Their preparation and use in imaging systems is described in U.S. Pat. Nos. 3,567,453; 4,307,182; 4,343,891; 4,447,521; 4,450,227; and 4,772,541. One set of complexes useful in practice of the present invention can be represented by the general formula (I):

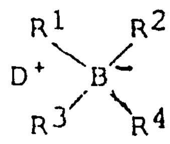

(I)

where D+ is a cationic dye; and $R^1$, $R^2$, $R^3$ and $R^4$ are independently selected from substituted or unsubstituted alkyl, aryl, alkaryl, allyl, aralkyl, alkenyl, alkynyl, alicyclic, cyclic and non-cyclic alkoxymethyls and aroxymethyls,

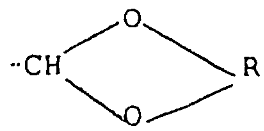

(R=alkyl or aryl)

and saturated or unsaturated heterocyclic groups.

Useful dyes form photoreducible but dark stable complexes with borate anions and can be cationic methine, polymethine, triarylmethane, indoline, thiazine, xanthene, oxazine and acridine dyes. More specifically, the dyes may be cationic cyanine, hemicyanine, dicarbocyanine tricarbocyanine, rhodamine and azomethine dyes. In addition to being cationic, the dyes should not contain groups which would neutralize or desensitize the complex or render the complex poorly dark stable. Examples of groups which generally should not be present in the dye are acid groups such as free carboxylic or sulfonic acid groups.

Preferred examples of useful cationic dyes are cyanine dyes of the general formula (II)

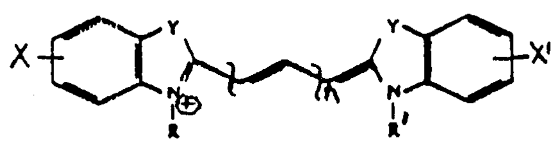

(II)

wherein:

X and X′ each independently represent H, electron donating or electron withdrawing groups

n = 0, 1, 2, or 3

Y = CH=CH, N-R(R=alkyl), $C(CH_3)_2$, O, S, Se

R′, R = alkyl, aryl, and any combination thereof.

Examples of electron donating groups which X and/or X′ can represent include $-N(CH_3)_2$, $-NH_2$, -OH, $-OCH_3$, $-C(CH_3)_3$ and $-CH_3$. Examples of electron withdrawing groups which X and/or X′ can represent include $-C_6H_5$, -F, -Cl, -Br, -I, COOH, -COOR (R=alkyl), $-COCH_3$, $-CF_3$, -CN, $-SO_2CH_3$ and $-NO_2$.

While we have not had an opportunity to test them yet, the specific cationic cyanine dyes disclosed in US pat. No: 3,495,987 should be useful in practice of the present invention.

The borate anion is designed such that the boranyl radical generated upon exposure to light and after electron transfer to the dye readily dissociates with the formation of a radical as follows:

$BR_4^{\bullet} \rightarrow BR_3 + R^{\bullet}$

Preferably, at least one but not more than three of $R^1$, $R^2$, $R^3$, and $R^4$ in formula (I) is an alkyl group. Each of $R^1$, $R^2$, $R^3$ and $R^4$ can contain up to 20 carbon atoms, and they typically contain 1 to 7 carbon atoms. More preferably $R^1$-$R^4$ are a combination of alkyl group(s) and aryl group(s) or aralkyl group(s) and still more preferably a combination of three substituted aryl groups and one alkyl group and even still more preferably a combination of three substituted aryl groups and one alkoxymethyl or aroxymethyl group.

Representative examples of alkyl groups represented by $R^1$-$R^4$ are methyl, ethyl, propyl, butyl, pentyl, hexyl, octyl, stearyl, tert-butyl, sec-buty, neopentyl, etc. The alkyl groups may be substituted, for example, by one or more halogen, cyano, acyloxy, acyl, alkoxy or hydroxy groups. Representative examples of alkoxymethyl and aroxymethyl groups include $-CH_2OR$, $-CH(OR)_2$,

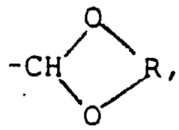

where R is alkyl, alkylene, aryl, arylene, etc.

Representative examples of aryl groups represented by $R^1$-$R^4$ include phenyl, naphthyl and substituted aryl groups such as anisyl and alkaryl such as methylphenyl, dimethylphenyl, etc. Representative examples of aralkyl groups represented by $R^1$-$R^4$ groups include benzyl. Representative alicyclic groups include cyclobutyl, cyclopentyl, and cyclohexyl groups. The aryl and aralkyl groups may include electron withdrawing groups present on the ring structure. Examples of an alkynyl group are propynyl and ethynyl, and examples of alkenyl groups include a vinyl group.

The borate an ion should be constructed such that the group which becomes the free radical species oxidized by the onium salt has an oxidation potential low enough to be oxidized by the onium salts. The free radical should have an oxidation potential less than -1.0 volts, and more preferably, less than -0.7 volts. Examples of borate anions capable of producing suitable free radical species are shown in formula (III).

$AR_3BR^-$ (III)

where Ar = substituted or unsubstituted aryl group; and

R = $_a$ benzyl, methylbenzyl, 1-methyl-1-phenylethyl, diphenylmethyl, 1,1-diphenylethyl, 9-fluorenyl, tert-butyl, sec-butyl, simple and substituted allyl, methoxymethyl, 1-ethoxyethyl, 2-isopropoxy-2-propyl, 2-tetrahydrofuranyl, 1, 4-dioxolan-2-yl, 1 ,3-dioxolan-2-yl, 1,3-dioxolan-4-yl, 1,3,5-trioxan-2-yl, or

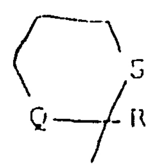

where Q = S or O and

R = H, alkyl $C_1$-C20), aryl, aralkyl, $-SiR'_3$, $-SeR'_3$ or-GeR′ where R′ = H, alkyl, aryl or aralkyl.

Borate anions have a high enough oxidation potential to prevent transfer of electrons from the ground state borate to the onium salt. As discussed above, preferred examples for use with onium salts, and particularly iodonium salts include the combination of three halogen substituted aryl groups and one alkyl, alkoxymethyl or aroxymethyl group. An example of a particularly preferred anion is tri-(4-fluorophenyl)-n-butyl borate. We have discovered that in some instances where a borate anion is combined with an onium salt the resulting photoinitiator is not dark stable in that it will polymerize or depolymerize the polymerizable or depolymerizable compound in the absence of visible light. For example, the combination of a cyanine dye-triphenyl-benzyl-borate complex with an onium salt may prematurely cure a polymerizable monomer when stored in the dark.

Specific examples of cationic dye-borate anion complexes useful in practice of the present invention are shown in the following table with their λ max.

1. 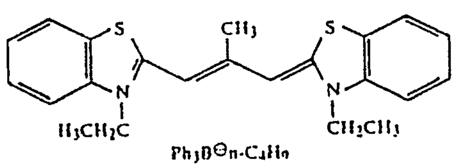 552 nm

2. 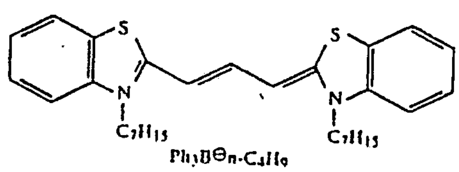 568 nm

3.

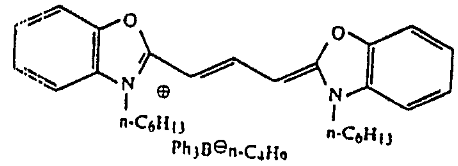

492 nm

4.

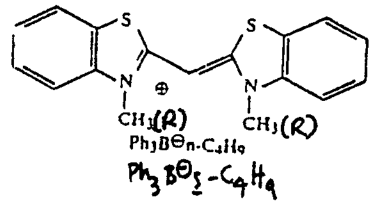

428 nm

R= C7, C10, C12, C14 groups

5.

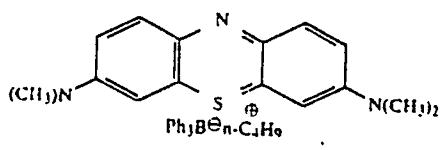

658 nm

6.

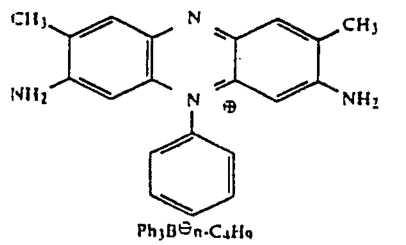

528 nm

7.

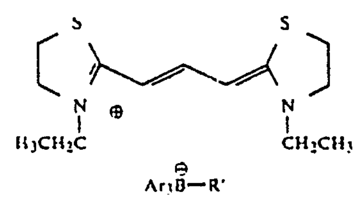

450 nm

| No. | R' | Ar |
|---|---|---|
| 7A | n-butyl | phenyl |
| 7B | n-hexyl | phenyl |
| 7C | n-butyl | anisyl |

8.

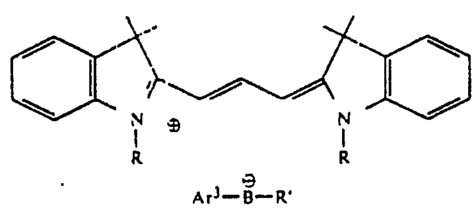

550 nm

| No. | R | R' | Ar | No. | R | R' | Ar |
|---|---|---|---|---|---|---|---|
| 8A | methyl | n-butyl | phenyl | 8H | n-heptyl | sec-butyl | phenyl |
| 8B | methyl | n-hexyl | phenyl | 8I | n-heptyl | cyclopentyl | phenyl |
| 8C | n-butyl | n-butyl | phenyl | 8J | n-heptyl | neopentyl | phenyl |
| 8D | n-butyl | n-hexyl | phenyl | 8K | n-heptyl | benzyl | phenyl |
| 8E | n-heptyl | n-butyl | phenyl | | | | |
| 8F | n-heptyl | n-hexyl | phenyl | | | | |
| 8G | ethyl | n-butyl | phenyl | | | | |

9.

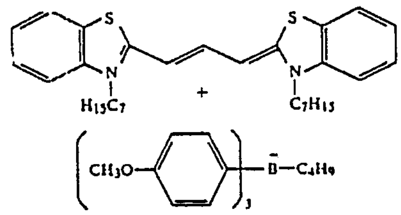

570 nm System

10.

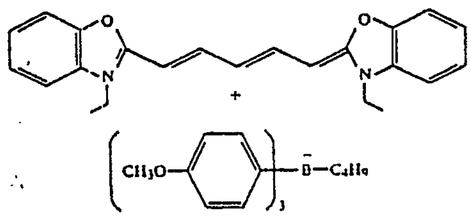

590 nm System

11.

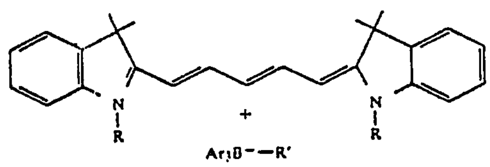

640 nm

| No. | R | R' | Ar | No. | R | R' | Ar |
|---|---|---|---|---|---|---|---|
| 11A | methyl | n-butyl | phenyl | 11J | n-heptyl | sec-butyl | phenyl |
| 11B | methyl | n-hexyl | phenyl | 11K | n-heptyl | cyclopentyl | phenyl |
| 11C | n-butyl | n-butyl | phenyl | 11L | n-heptyl | neopentyl | phenyl |
| 11D | n-butyl | n-hexyl | phenyl | 11M | n-heptyl | benzyl | phenyl |
| 11E | n-phenyl | n-butyl | phenyl | | | | |
| 11F | n-pentyl | n-hexyl | phenyl | | | | |
| 11G | n-heptyl | n-butyl | phenyl | | | | |
| 11H | n-heptyl | n-hexyl | phenyl | | | | |
| 11I | methyl | n-butyl | anisyl | | | | |

12.

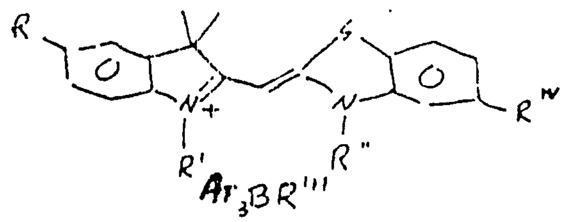

| No. | R | $R^{I}$ | $R^{II}$ | $R^{III}$ | $R^{IV}$ | Ar |
|---|---|---|---|---|---|---|
| 12A | H | $CH_3$ | n-heptyl | n-butyl | H | phenyl |
| 12B | H | $CH_3$ | n-heptyl | sec-butyl | H | phenyl |
| 12C | Cl | $CH_3$ | n-heptyl | n-butyl | H | phenyl |
| 12D | Cl | $CH_3$ | n-heptyl | sec-butyl | H | phenyl |
| 12E | H | $CH_3$ | n-heptyl | n-butyl | $OCH_3$ | phenyl |
| 12F | Cl | $CH_3$ | n-heptyl | n-butyl | $OCH_3$ | phenyl |
| 12G | Cl | $CH_3$ | n-decyl | n-butyl | F | phenyl |

740 nm System

13.

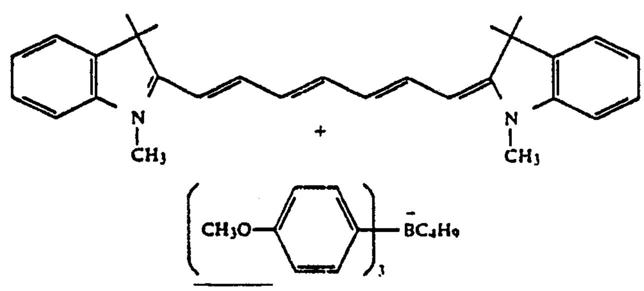

Anionic dye compounds are also useful in practice of the present invention.

Anionic dye-iodonium ion compounds of the formula (IV):

$[R^{10}\text{-}I^{\oplus} - R^{11}]_n D^{-n}$ (IV)

where $D^-$ is an anionic dye and $R^{10}$ and $R^{11}$ are independently selected from the group consisting of aromatic nucleii such as phenyl or naphthyl or $R^{10}$ and $R^{11}$ together form a divalent aromatic nucleus and n is 1 or 2, are useful in practice of the present invention.

Anionic dye-pyryllium compounds of the formula (V):

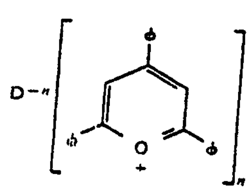

(V)

where $D^-$ and n are as defined above and $\phi$ represents a phenyl group, are also useful in practice of the present invention.

Anionic dye sulfonium complexes of the fromula (VI):

$D^{-n}[R^{12} R^{13} R^{14} S]_n$ (VI)

where D and n are defined as above and $R^{12}$, $R^{13}$ and $R^{14}$ represent aliphatic or aromatic radicals such as

alkyl or aryl radicals and two of $R^{12}$, $R^{13}$, and $R^{14}$ may combine to form a divalent heterocyclic or fused ring structure and are useful in practice of this invention. One example is a diphenylmethyl sulfonium ion.

Anionic dye phosphonium complexes of the formula (VII):

$D^{-n}[R^{15}R^{16}R^{17}R^{18P}]_n$ (VII)

where D and n are defined as above and $R^{15}$ -$R^{18}$ may represent aryl groups such as phenyl or an aralkyl group such as benzyl are also useful in practice of the present invention. A particular phosphonium ion is a triphenylbenzyl phosphonium ion.

Representative examples of anionic dyes include xanthene and oxonal dyes. For example Rose Bengal, eosin, erythrosin, and fluorscein dyes are useful. In addition to iodonium and pyryllium ions, other compounds of anionic dyes and sulfonium and phosphonium cations are potentially useful. As in the case of the cationic dye compounds, useful dye-cation combinations can be identified through the Weller equation as having a negative free energy.

Selected examples of anionic dye compounds are shown in Table 2 where the symbol $\phi$ designates a phenyl group and the structure

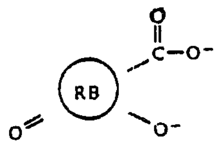

is used for

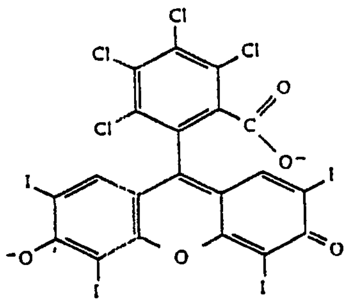

TABLE 2

| | |
|---|---|
| 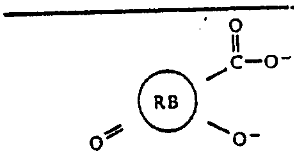 | $(\phi_2I^+)_2$ |
| 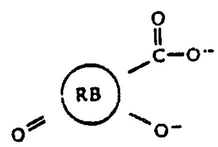 | 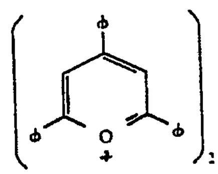 |
| 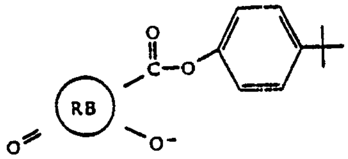 | 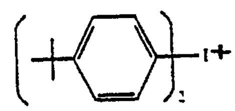 |
| 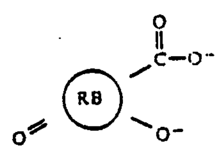 | 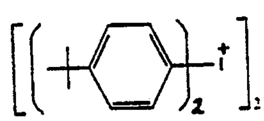 |
| 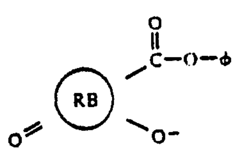 | 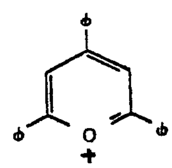 |
| 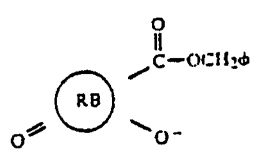 | $\phi_2I^+$ |

TABLE 2-continued

| | |
|---|---|
| 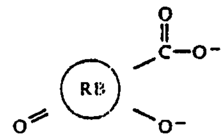 | $[\phi_3\overset{+}{P}CH_2\phi]_2$ |
| 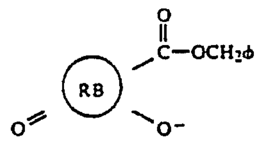 | $\phi_3\overset{+}{P}CH_2\phi$ |
| 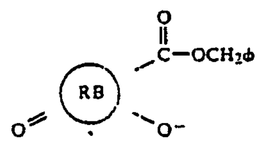 | $CH_3\overset{+}{S}\phi_2$ |
| 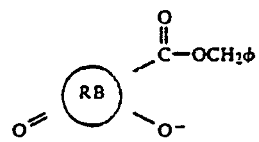 | 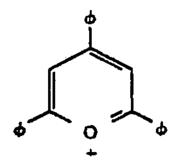 |
| 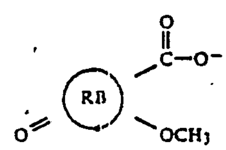 | $\phi_2I^+$ |

The photoinitiator also includes an onium salt which, when reduced by the radical generated by the exposure of the ionic dye reactive counter ion complex to visible light, is capable of forming a cation. Onium salts capable of forming or causing the formation of cations are known in the art and typically take the form of diarylhalonium, triarylsulfonium or phenacylsulfonium salts. Useful onium salts include triarylsulfonium hexafluorophosphates, triarylsulfonium hexafluoroarsenates, triarylsulfonium hexafluoroantimonates, triarylsulfonium tetrafluoroborates, diaryliodonium hexafluorophosphates, diaryliodonium hexafluoroarsenates, diaryliodonium hexafluoroantimonates, diaryliodonium tetrafluoroborates, dialkylphenacylsulfonium tetrafluoroborates, dialkylphenacylsulfonium hexafluorophosphates, dialkyl-4-hydroxphenylsulfonium tetrafluoroborates and dialkyl-4-hydroxphenylsulfonium hexafluorophosphates.

The onium salts which may be selected for use in practice of the present invention must have a reduction potential which is less negative than the oxidation potential of the radical species generated by the photolysis of the ionic dye reactive conversion complex. For example, radicals generated from a dye-borate complex generally have an oxidation potential of about -0.7 to -1.1 volts. By selecting an onium salt which has a reduction potential less negative than -0.7 volts, the radical/onium salt combination will be capable of generating cations by transferring an electron from the radical to the onium salt. Particularly good results occur where the reduction potential is in the range of -0.2 to -0.5 volts. Accordingly, the onium salts listed below are merely examples of those which are suitable for use in practice of the present invention. Those skilled in the art will be able to determine other onium salts which are usable by reference to their reduction potential. Similarly, the above listed anions are preferably selected to have oxidation potentials more negative than the onium salt reduction potentials, and are considered representative examples.

When the onium salt is a iodonium salt, it typically is of formula (VIII):

$[R^5{}_aR^6{}_bI]_c{}^+ \; [MQ_d]^{-(d-e)}$ (VIII)

where $R^5$ is a monovalent aromatic organic radical, $R^6$ is a divalent organic radical, M is a metal or a metalloid and Q is a halogen radical, a and b are whole numbers equal to 0, 1 or 2, the sum of a+b is equal to 2 or the valence of I,

c=d-e

e=valence of M and is an integer equal to 2 to 7 inclusive; and

d is > e and is an integer having a value up to 8.

Radicals included by $R^5$ can be the same or different aromatic, carbocyclic or heterocyclic radicals

having from 6 to 20 carbon atoms, which can be substituted on the ring with from 1 to 4 monovalent radicals selected from $C_{(1-18)}$ alkoxy, $C_{(1-18)}$ alkyl, nitro, chloro, etc., $R^5$ is more particularly phenyl, chlorophenyl, nitrophenyl, methoxyphenyl, pyridyl, etc. Radicals included by $R^6$ are divalent radicals such as

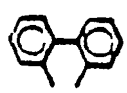
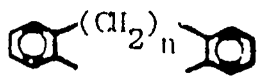

etc. Metal or metalloids included by M of formula (VIII) are transition metals such as Sb, Fe, Sn, Bi, Al, Ga, In, Ti, Zr, Sc, V, Cr, Mn, Cs, rare earth elements such as the lanthanides, for example, Cd, Pr, Nd, etc., actinides, such as Th, Pa, U, Np, etc. and metalloids such as B, P, As, etc. Complex anions included by $MQ_d^{-(d-e)}$ are, for example, $BF_4^-$, $PF_6^-$, $AsF_6^-$, $SbF_6^-$, $FeCl_4^=$, $SnCl_6^=$, $SbCl_6^-$, $BiCl_3^=$, etc. Particularly good results are obtained when using metal or metalloid compounds having a low nucleophilicity, particularly $BF_4^-$, $SbF_6^-$, $AsF_6^-$ and $PF_6^-$.

Halonium salts, preferably iodonium salts, included by formula VIII are, for example,

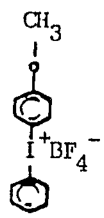
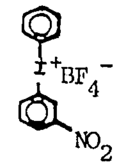
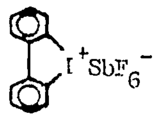
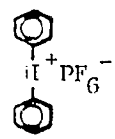
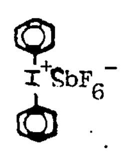
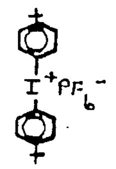
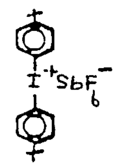

The halonium salts of formula III are made by the procedures described by O. A. Ptitsyna, M. E. Pudecva, et al., Dokl, Adad Nauk, SSSR, 163, 383 (1965); Dokl, Chem., 163, 671 (1965). F. Marshall Beringer, M. Drexler, E. M. Gindler, J. Am. Chem. Soc. , 75, 2705 (1953). J. Collette, D. McGreer, R. Crawford, et al., J. Am. Chem. Soc. 78, 3819 (1956). Other aryliodonium salts include the polymeric iodonium salts which are described in US Patent No: 4,780,511 and are to be regarded as hereby incorporated by reference.

Particularly preferred onium salts of formula (VIII) include salts having the following structures: $(C_nH_{2n+1}C_6H_4)\,I^+(C_6H_5)$, $(C_nH_{2n+1}C_6H_4)_2\,I^+$, $(C_nH_{2n+1}OC_6H_4)\,I^+(C_6H_5)$ and $(C_nH_{2n+1}OC_6H_4)_2\,I^+$ where n = 8 to 12.

When the onium salt is a sulfonium salt, it is preferably of formula (IX):

$[R^7{}_fR^8{}_gR^9{}_hS]^+[MQ_n]^-$ (IX)

wherein $R^7$ is a monovalent aromatic organic radical, $R^8$ is a monovalent organic aliphatic radical selected from alkyl, cyanoalkyl and substituted alkyl, $R^9$ is a polyvalent organic radical forming a heterocyclic or fused ring structure, M is a metal or metalloid as defined with respect to formula (VIII), Q is a halogen radical as defined with respect to formula (VIII), f is a whole number ewqual to 0 to 3 inclusive, g is a whole number equal to 0 to 2 inclusive, h is a whole number equal to 0 or 1, and the sum of f, g and h is equal to 1 to 3 inclusive, and n is an integer equal to 4 to 6 inclusive as defined with respect to formula (VIII).

Examples of Sulfonium salts useful in practice of the present invention include:

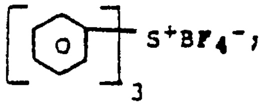

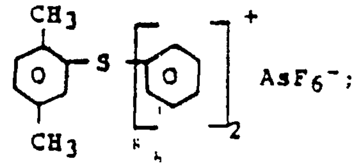

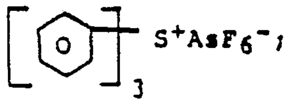

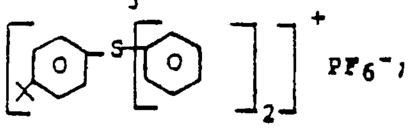

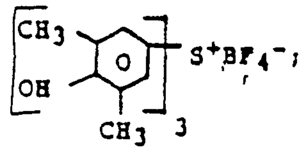 and

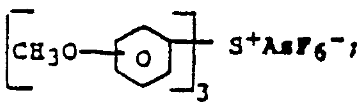

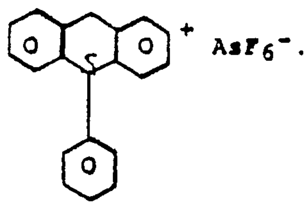

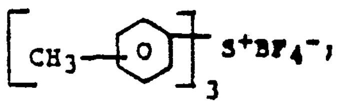

Particularly preferred sulfonium salts are 4-(phenylthio)phenyl-diphenyl sulfonium salts. Other sulfonium salts whose reduction potential is less negative than -0.7 volts include

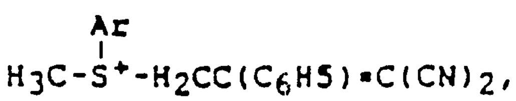

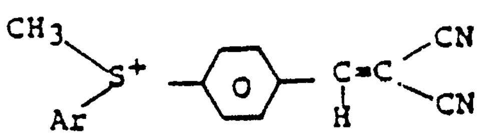 ,

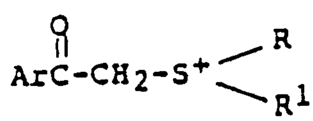 ,

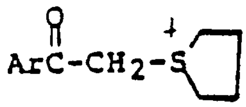 ,

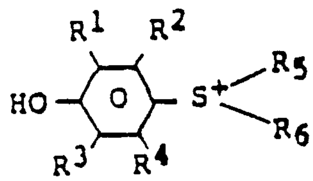 ,

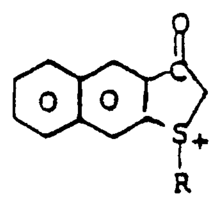

and 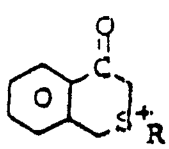

, where R, $R^1$, $R^2$, $R^3$, $R^4$, $R^5$ = alkyl, aryl, alkaryl, etc. and wherein Ar is an aryl group including one or more aromatic rings.

In addition, phosphonium salts of formula

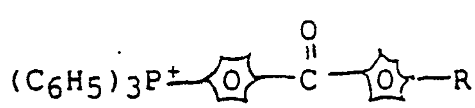

ferrocenium salts of formula

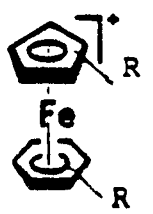 , 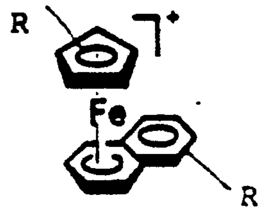 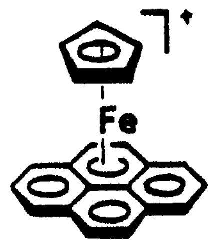 ;

and diazonium salts of formula
$ArN_2^+$
R,R[1] and Ar being as defined above as well as azinium, pyrylium and thiapyrylium may be utilized as long as their reduction potential is less negative than -0.7 volts.

The amount of ionic dye reactive counter ion complex in the composition ranges from about 0.01 parts to about 10 parts per 100 parts of the polymerizable or depolymerizable compound. The amount of onium salt in the composition ranges from about 0.001 parts to about 10 parts per 100 parts polymerizable or depolymerizable compound.

As discussed above, the utilization of the inventive photoinitiator can regenerate radicals (i.e. quantum efficiency of radical generation exceeds unity). In the case where one or more than one of the generated radicals has an oxidation potential less negative than the reduction potential of the onium salt selected, chain transfer agents can be added to enable the radical/chain transfer agent combination to transfer an electron to the onium salt and generate a cation. As a result, the photoinitiation efficiency is improved. Examples of chain transfer agents which may be added include ethylene glycol, benzyl alcohol, alkoxy methylalcohol, aroxy methylalcohol, tetrahydrofuran, dioxane, and $Ar_2C=$ 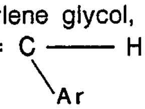

, Ar = an aryl group.

While not wishing to be bound by any theory, we hypothesize that upon exposure of the photoinitiator to visible light, the cationic dye is excited and accepts an electron from the dye complex and generates a dye radical. Similarly, after electron transfer, the complex reacts by a mechanism which is not clear to form a different radical. These radicals then react directly with the onium salt, which undergoes electron transfer and releases an acid or a cationic species which can initiate polymeriation or depolymerization of a compound. In the embodiments where one or more of the radicals do not react with the onium salt, the addition of a chain transfer agent combines with the unreacted radical to generate a different radical which has a more negative oxidation potential so that it can directly react with the onium salt to liberate a cation. Further, since a radical is regenerated from the onium salt, it continued to generate acids or cations to improve the efficiency of photoinitiation. For example, the release of one free radical may lead to the generation of greater than 20 cations. The excellent quantum efficiency is particularly pronounced when conducted in an oxygen free environment (e.g., efficiencies can improve by a factor of 10).

A further consideration with respect to the photoinitiators is that to initially generate free radicals upon exposure to visible light, the exposure be conducted in the relative absence of oxygen. The presence of oxygen can inhibit the formation of free radicals, or, in the alternative, can react with the free radicals before they have had an opportunity to undergo electron transfer with the onium salt. However, once the radical has reacted with the onium salt to liberate an acid or a cation, oxygen inhibition is no longed a risk as oxygen does not react with the cation or acid species. In addition to the increased quantum efficiency associated with cation generation, the reduced role of oxygen inhibition also contributes to improved rates of photopolymerization.

To improve the photosensitive properties of the initiator system, additives, other than the above discussed chain transfer agents nay be included. These can be thiol materials such as acylthiohydroxamates, 2-mercaptobenzothiazole, 6-ethoxy-2-mercaptobenzothiazole, 2-mercaptobenzoxazole and phenylmercaptotetrazole. Disulfides of the above listed thiol components are useful components. Those additives are preferably present in concentrations of about 0.1 to 10 percent by weight of the composition.

The ionic dye reactive counter ion complex and onium salt components should be carefully selected to provide an optimal initiator. In particular, the onium salt should be selected to have a reduction potential less negative than the oxidation potential of the free radical species. However, in some instances, due to the highly reactive nature of the respective components some component combinations react to cause the release of free radicals and cations or acid species in the absence of light and thereby prematurely

polymerize or depolymerize the polymerizable or depolymerizable compound. We have discovered that the problems are primarily a function of the substituents present in the different components. For example, successful results have been obtained when utilizing 1,1′-di-n-heptyl-3,3,3′,3′-tetramethylindocarbocyanine tris-(4-fluorophenyl)-n-butyl borate as the ionic dye reactive counter ion complex and diphenyliodonium hexafluorophosphate or as the onium salt. By comparison, poor dark stability was observed when triphenylbenzylborate was used as the ionic dye reactive counter ion complex.

The compositions coated upon a support in a conventional manner and used as a photoresist or in photolithography to form a polymer image; they can be used as adhesives or coatings and the like; or they can be encapsulated as described in U.S. Patents 4,399,209 and 4,440,846 and used to control the release of an image-forming agent. The later processes typically involve image-wise exposing the photosensitive material to actinic radiation and subjecting the layer of microcapsules to a uniform rupturing force such as pressure, abrasion, or ultrasonic energy. Depolymerizable compositions can be encapsulated as described in the referenced patents or formed into microparticles as described in U.S. Patent 4,788,125. The use of depolymerizable particles is preferable to the use of depolymerizable microcapsules.

In particular, the utilization of the inventive photoinitiator with photoadhesive microparticles is particularly preferred. Examples of photoadhesive microparticles, and methods for producing the microparticles are described in greater detail in our European Patent Application No: 88304612.0 (Publication No: EP A 0292323). To the extent necessary, the teachings of that application are hereby incorporated by reference.

When producing photoadhesive microparticles, the microparticles are designed with photoadhesive characteristics such that particles exposed to radiation become tacky and are transferred, upon contact and application of pressure, to an image-receiving sheet (e.g., paper), while particles in the unexposed areas remain non-tacky and are not transferred. In this manner, an image is formed by the transfer particles on the image-receiving sheet or by the untransferred particles which remain on the donor sheet.

As described in greater detail in our aforesaid European Application No: 88304612.0, the microparticles are formed from a phototackifiable composition. The microparticles may be formed by compounding the phototackifiable composition with an image-forming agent in which the particle may simply be a composite, solid solution or mixture of the two materials. Alternatively, the microparticles are formed by coating a pigment or dyed particle with a layer of a phototackifiable composition.

The photosensitive compositions used in forming the microparticles property of being capable of forming into discrete particles and the property of becoming selectively tacky upon exposure to actinic radiation. Compositions having these properties are known in the art, particularly in the area of peeling development systems.

Each microparticle includes the reactive counter ion onium salt initiator which generates an acid or a cation which intiates depolymerization upon exposure. The initiator may be incorporated into the polymer chain, appended to the polymer chain, or simply mixed with the polymer.

Various methods can be used to form microparticles including the photoinitiator, and image-forming agent) in a water-miscible or a water immiscible solvent can be added to an aqueous solution of a stabilizing agent (e.g., an anionic, amphoteric or ionic surfactant such as sodium lauryl sulfate; pectin; or polyvinyl alcohol) under high shear mixing and the dispersion or suspension, is coated on a support and the water removed through drying. Where the solvent used is immiscible in water, it is preferably removed prior to coating.

Alternatively, a polymer melt containing additives can be dispersed into an aqueous solution of an appropriate surfactant without a solvent and the dispersion can be coated on an appropriate support. Another method which can be used to form the microparticles is spray drying wherein a solution of the polymer and additives is aspirated into a heated air space.

In a particularly preferred use, the inventive materials are useful in forming images, and in particular full color images. Several processes can be used to form color images as explained in U.K. Patent No. 2,113,860 and U.S. Patent 4,772,541.

At least one set of the microcapsules or microparticles in a full color system contains a composition including an ionic dye reactive counter ion complex onium salt photoinitiator. The other sets also may include similar types of photoinitiators, or they may contain conventional photoinitiators.

In preferred embodiments, a full colour imaging system is provided in which three sets of microcapsules or microparticles containing cyan, magenta and yellow image-forming agents are sensitive to red, green, and blue light respectively. The photosensitive composition in at least one and possibly all three sets of microcapsules or microparticles are sensitized by photoinitiators containing an ionic dye reactive counter ion complex and an onium salt. For optimum color balance, the microcapsules are sensitive (λ max) at about 450 nm, 550 nm, and 650 nm, respectively. Such a system is useful with visible light sources in direct transmission or reflection imaging. Such a material is useful in making copies of full-color originals or

contact or projected prints of color photographic slides. They are also useful in electronic imaging using lasers, pencil light sources, fiber optic cathode ray tubes, liquid crystals which transmit light of appropriate wavelengths and x-ray imaging sources.

If the photosensitive compositions are encapsulated, they can be encapsulated in various wall formers using techniques known in the area of carbonless paper including coacervation, interfacial polymerization, polymerization of one or more monomers in an oil, as well as various melting, dispersing, and cooling methods. To achieve maximum sensitivities, it is important that an encapsulation technique be used which provides high quality capsules which are responsive to changes in the internal phase viscosity in terms of their ability to rupture. Encapsulation procedures conducted at higher pH levels (e.g., greater than about 6) are preferred.

Urea-resorcinol-formaldehyde and melamine-formaldehyde capsules with low oxygen permeability are preferred. Alternatively, microcapsules having cyanoacrylate walls as described in our European Patent Application No: 9030282918 (Publication No: EP-A- ), may be utilised. The disclosure of this application is to be regarded as hereby incorporated by reference. In some cases to reduce oxygen and water permeability it is desirable to form a double walled capsule by conducting encapsulation in two stages. It is particularly important that the capsule walls be relatively water impermeable to prevent premature termination of the cation by reaction with water.

Our photosensitive material can be used to control the interaction of various image-forming agents.

In one embodiment, the capsules may contain a benign visible dye in the internal phase in which case images are formed by contacting the exposed imaging material under pressure with a plain paper or a paper treated to enhance its affinity for the visible dye. A benign dye is a colored dye which does not react with the photoinitiator or otherwise interfere with the imaging photochemistry, for example, by quenching the excited state of the initiator or produced cation or detrimentally absorbing or attenuating the exposure radiation.

In a preferred embodiment, images are formed through the reaction of a pair of chromogenic materials such as a color precursor and a color developer, either of which may be encapsulated with the photohardenable composition and function as the image-forming agent. In general, these materials include colorless electron donating type compounds and are well known in the art. The color formers selected must not contain functional groups which could react with the cations or acid species generated by the photoinitiator to prematurely form an image prior to transfer. Accordingly, several acid reactive chromogenic compounds typically used in imaging systems (e.g. compounds containing basic groups), such as several leuco dyes, may not be suitable for use in certain embodiments of the present invention. Representative examples of color formers suitable for use in this system include base-developable chromogenic material. These materials are also leuco compounds and include the phenolphthaleins such as sulfobromophthalein sodium tetrahydrate, phenolphthalein, bromophenol blue, bromocresol green, bromocresol purple, and bromothymol blue.

Examples of basic developer materials include weak bases such as sodium carboxylate and strong bases such as ammonia, hydrazine and organoamines.

Other image-forming reactions include maintaining an ultraviolet developable dye precursor on the imaging sheet and developing the precursor into an image by exposure to ultraviolet radiation. Examples of ultraviolet developable dye precursors include triarylmethyl halides and nitrones as described in Kosar, <u>Light Sensitive Systems</u> , p. 370 (1965) and in Jacobson, <u>Imaging Systems</u> , Chapter XI (1975). The dye coupling mechanism useful for forming images in silver halide film technology may also be employed. Examples of suitable materials are disclosed in the above references, and also in The Color Index.

As indicated in U.S. Patents 4,399,209 and 4,440,846, the developer may be present on the photosensitive sheet (providing a so-called self-contained system) or on a separate developer sheet.

In self-contained systems, the developer may be provided in a single layer underlying the microcapsules or microparticles as disclosed in U.S. Patent No. 4,440,846. Alternatively, the color former and the color developer may be individually encapsulated in sets of photosensitive capsules or particles and upon exposure both capsule or particle sets image-wise rupture, releasing color former and developer which mix to form the image. Alternatively, the developer can be encapsulated in non-photosensitive capsules such that upon processing all developer capsules rupture and release developer but the color former containing capsules or particles rupture in only the unexposed or under-exposed area which are the only areas where the color former and developer mix. Still another alternative is to encapsulate the developer in photosensitive capsules or particles and the color former in non-photosensitive capsules.

When our photoinitiators are associated with adhesive microparticles which are rendered tacky upon exposure to radiation, the following procedure should be utilized. The microparticles are distributed onto a support member. The microparticles are held in position by gravity or by a weak adhesive. The layer of

microparticles are image-wise exposed to actinic radiation. The exposed layer of microparticles is contacted with an image receiving sheet. This can be a sheet of palin paper or a sheet which has been designed by coating or preparation to accept or adhere the microparticles. By the application of pressure, the exposed microparticles in the exposed areas selectively adhere to the receiver sheet while the unexposed microparticles remain on the imaging support. Developing the microparticles on the receiver sheet produces a negative image. To produce a positive image, the microcapsules remaining on the imaging sheet may then be exposed to radiation and transferred to a receiver sheet. Accordingly, a single imaging sheet containing photoadhesive microparticles can be used to produce both positive and negative images.

The image-forming agent need not necessarily be present in the internal phase. Rather, this agent may be present in the capsule wall of a discrete capsule or in the binder of an open phase system or in a binder or coating used in combination with discrete capsules or an open phase system designed such that the image-wise ruptured capsules release a solvent for the image-forming agent. Embodiments are also envisioned in which a dye or chromogenic material is fixed in a capsule wall or binder and is released by interaction with the internal phase upon rupturing the capsules.

The most suitable substrate is a synthetic film and preferably a metallized film.

The invention is illustrated by the following non-limiting examples.

## Comparative Example 1

A composition containing 3 parts of 1,1′-di-n -heptyl-3,3,3′,3′-tetramethylindocarbocyanine tri-4-fluorophenyl-n-butyl borate and 99.7 parts of triethyleneglycol divinylether (TEGDVE) was coated onto a glass microscope slide and was covered with another glass microscope slide. The assembly was exposed to light from a 120 watt tungsten halogen light source at a distance of 35 cm. The composition did not photopolymerize.

## Comparative Example 2

The experiment of Comparative Example 1 was repeated with a composition containing .79 parts of diphenyliodonum hexafluorophosphate and 99.21 parts of triethyleneglycol divinylether (TEGDVE). The composition did not photopolymerize.

## Example 3

The experiment of Comparative Example 1 was repeated with a composition containing .3 parts of 1,1′-di-n - heptyl-3,3,3′,3′-tetramethylindocarbocyanine tri-4-fluorophenyl-n-butyl borate, .79 parts of diphenyliodonium hexafluorophosphate and 98.91 parts of TEGDVE. The composition photopolymerized within 5 seconds.

## Comparative Example 4

The experiment of Example 3 was repeated except that the composition additionally contained about 1 part of 2,6-diisopropyldimethylaniline (DIDMA), a known autoxidizer material. The composition did not photopolymerize, indicating that DIDMA inhibited photopolymerization.

## Comparative Example 5

A composition coating containing .3 parts of 1,1′-di-n -heptyl-3,3,3′,3′-tetramethylindocarbocyanine triphenylbenzyl borate, .79 parts of diphenyliodonium hexafluorophosphate and 98.91 parts of TEGDVE was

stored for a period of 10 minutes in a dark room. After storage, the composition was examined and found to have photopolymerized. Accordingly, the dark stability of the composition was very poor.

## Example 6

The experiment of Comparative Example 5 was repeated using a composition containing .3 parts of 1,1′-di-n -heptyl-3,3,3′,3′ -tetramethylindocarbocyanine triphenyl-n -butylborate, .79 parts of diphenyliodonium hexafluorophosphate and 98.91 parts of TEGDVE. A good dark stability was observed for several weeks. The composition was exposed to visible light and completely photopolymerized.

## Example 7

The experiment of Comparative Example 5 was repeated using a composition containing .3 parts of 1,1′-di-n -heptyl-3,3,3′,3′-tetramethylindocarbocyanine tri-4-fluorophenyl-n-butylborate, .79 parts of diphenyliodonium hexafluorophosphate and 98.91 parts of TEGDVE. None of the composition had polymerized over an extended period of time, indicating an excellent dark stability. When exposed to visible light, th composition completely photopolymerized.

As demonstrated by the above examples, the utilization of certain ionic dye reactive counter ion complex/onium salt photoinitiators enables the polymerization of cationic polymerizable monomers, particularly upon exposure to visible and near infrared wavelengths. This provides a significant number advantages in comparison to prior art systems utilizing free radical photoinitiators. Polymerizable materials, such as epoxies and vinyl ethers cannot be polymerized upon exposure to visible light in the presence of either ionic dye reactive counter ion complexes or onium salts alone, but are polymerizable upon exposure to visible light when the different types of photoinitiator are combined.

A further advantage when the present photoinitiators are used in imaging systems is that the polymerizable materials are less toxic than prior art imaging materials. For example, epoxy and vinyl ether compounds are much less toxic than acrylate monomers. Accordingly, the compositions are potentially more safe to handle in everyday use.

In addition, the utilization of cationic initiation enables the use of several depolymerizable compositions. Thus, a visible light non-pressure developable depolymerizable imaging system can be developed, and more particularly, a panchromatic full color depolymerizable microparticle imaging system.

In addition, due to the utilization of cationic initiation as compared to free radical initiation, the efficiency of initiation is much greater, presumably due to the high quantum yield of cation generation and the resistance of cationic initiators to oxygen inhibition.

This can result in increased film speeds for the cationically initiated compositions. In fact, if the initiation takes place in a relatively inert environment, the behavior obtained is nearly digital, and as such the photosensitive composition is capable of producing highly contrasted images.

## Claims

1. A photohardenable or photosoftenable composition characterized in comprising: a cationically polymerizable or depolymerizable compound, and a photoinitiator including an ionic dye reactive counter ion complex and an onium salt and being capable of initiating cationic polymerization or depolymerization of said polymerizable or depolymerizable compound upon exposure to actinic radiation.

2. A composition according to Claim 1, further characterised in that said anionic dye is selected from xanthene and oxonol dyes.

3. A composition according to Claim 2, further characterised in that said dye is Rose Bengal.

4. A composition according to any of Claims 1, 2 or 3, further characterised in that said reactive counter ion is selected from iodonium, phosphonium, pyrylium, and sulfonium ions.

5. A composition according to Claim 1, further characterised in that said ionic dye reactive counter ion complex comprises a cationic dye-borate anion complex represented by the formula (I):

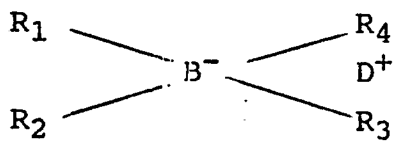

(I)

where D is a cationic dye moiety, and $R_1$, $R_2$, $R_3$ and $R_4$ are the same or different and are selected from substituted or unsubstituted alkyl, aryl, aralkyl, alkaryl, alkenyl, alkynyl, alicyclic, heterocyclic and allyl groups.

6. A composition according to Claim 5, further characterised in that said borate anion is of formula (III)

$AR_3BR''^-$

wherein $Ar_3$ = three substituted or unsubstituted aryl groups, which may be the same or different; and $R''$ = a benzyl, methylbenzyl, 1-methyl-1-phenyl ether, diphenylmethyl, 1,1-diphenylethyl, 9-fluorenyl, tertbutyl, sec-butyl, simple or substituted allyl, methoxymethyl, 1-ethoxyethyl, 2-isopropoxy-2-propyl, 2-tetrahydrofuranyl, 1,4-dioxolan-2-yl, 1,3-dioxolan-2-yl, 1,3-dioxolan-4-yl, 1,3,5-troxan-2-yl or

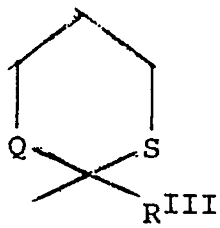

where Q = S or O and

$R'''$ = H, alkyl ($C_1$-$C_{20}$), aryl, aralkyl, $SiR'_3$, $-SeR'_3$ or $-GeR'$ where $R'$ = H, alkyl, aryl or aralkyl.

7. A composition according to Claim 6, further characterised in that said borate anion is tri-4-fluorophenyl n-butyl-borate.

8. A composition according to any one of Claims 5, 6 or 7, further characterised in that said cationic dye is selected from cationic cyanine, carbocyanine, hemicyanine, dicarbocyanine and tricarbocyanine dyes.

9. composition according to Claim 8, further characterised in that said cationic dye is of formula II

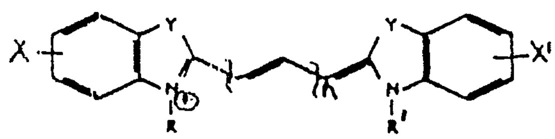

(II)

wherein X and $X'$ each independently represent H, electron donating or electron withdrawing groups;

n = 0,1,2 or 3

R,$R'$ are independently an alkyl group or aryl group; and

Y = -CH = CH-, $-N-CR_3-$(R = alkyl group), $-C(CH_3)_2-$,O,S, or Se.

10. A composition according to any of Claims 6 to 9, further characterised in that said composition further comprises a chain transfer agent adapted to combine with said cationic dye-borate an ion complex to generate a free radical which can react with said onium salt to liberate a cation.

11. A composition according to any of Claims 1 to 9, further characterised in that said onium salt has a reduction potential less negative than the oxidation potential of the radical generated by the photolysis of said ionic dye reactive counter ion complex.

12. A composition according to Claim 11, further characterised in that said onium salt has a reduction potential less negative than -0.7 volts.

13. A composition according to any preceding claim, further characterised in that said onium salt is selected from iodonium salts, sulfonium salts, phosphonium salts, diazonium salts, and ferrocenium salts.

14. A composition according to any preceding Claim, wherein said composition is photohardenable, and is further characterised in that said polymerizable compound is selected from epoxy compounds, vinyl or allyl monomers, vinyl or allylic prepolymers, vinyl ethers, vinyl ether functionalized prepolymers, cyclic ethers, cyclic esters, cyclic sulfides, melamine formaldehyde, phenolic formaldehyde; cyclic organosiloxanes, lactams and lactones, cyclic acetals and epoxy functional silicone oligomers.

15. A composition according to Claim 14, further characterised in that said photohardenable composition

further comprises an ethylenically unsaturated free radical polymerizable monomer, said photohardenable composition being polymerizable by cationic and free radical photopolymerization.

16. A composition according to Claims 14 or 15, further characterised in that said polymerizable compound is selected from glycidyl (meth)acrylates, epoxy acrylates, acrylated melamine formaldehyde and epoxidized siloxanes.

17. A composition according to any preceding claim, further characterised in that said composition is microencapsulated.

18. A composition according to any of Claims 1 to 13, wherein said composition is photosoftenable, and is further characterised in that said polymerizable compound is selected from acid degradable polyaldehydes including polyformals, poly(phthaldehyde), allylic and hindered polyesters, polycarbonates including hindered and allylic polycarbonates, polysiloxanes and polyethers.

19. A composition according to Claim 18, further characterised in that said composition is in the form of microparticles.

20. A composition according to any preceding claim, characterised in having an image-forming agent associated therewith.

21. A photosensitive material comprising a support having coated thereon a layer of photohardenable or photosoftenable composition in accordance with any of Claims 1 to 20.

22. Photosensitive material useful in forming full colour images and comprising a support having coated thereon a layer of a photohardenable or photosoftenable composition, said composition including a first set of microcapsules having a cyan image-forming agent associated therewith, a second set of microcapsules having a magenta image-forming agent associated therewith and a third set of microcapsules having a yellow image-forming agent associated therewith, characterised in that at least one of said first, second and third sets of microcapsules comprises a composition according to both Claims 17 and 20.

23. Material according to Claim 22, further characterised in that said first, second and third sets of microcapsules are respectively sensitive to red, green and blue light.

24. Photosensitive material useful in forming full colour images and comprising a support having coated thereon a layer of a photosoftenable composition, said composition including a first set of microparticles having a cyan image-forming agent associated therewith, a second set of microparticles having a magenta image-forming agent associated therewith and a third set of microparticles having a yellow image-forming agent associated therewith, characterised in that at least one of said first, second and third sets of microparticles comprises a composition according to both Claims 19 and 20.

25. Material according to Claim 24, further characterised in, that said first, second and third sets of microparticles are respectively sensitive to red, green and blue light.

26. The use of a photoinitiator including an ionic dye reactive counter ion complex and an onium salt to initiate cationic polymerization or depolymerization upon exposure to actinic radiation of a cationically polymerizable or depolymerizable compound.

27. A photoinitiator capable upon exposure to actinic radiation of producing cations to initiate cationic polymerization or depolymerization of a cationically polymerizable or depolymerizable compound, said photoinitiator comprising an ionic dye reactive counter ion complex and an ionium salt.

European Patent Office

# EUROPEAN SEARCH REPORT

Application Number

EP 90307201.5

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| D,X | US - A - 4 772 530 (GOTTSCHALK) * Claims; column 2, lines 1-22; column 5, line 15 - column 7, line 3; column 11, lines 22-27; column 13, lines 34-52 * | 1-17, 20-23, 26,27 | G 03 F 7/029<br>G 03 F 7/038<br>G 03 F 7/039<br>G 03 F 7/075<br>C 08 F 4/52 |
| X | US - A - 4 816 368 (SKAGGS) * Claims; table * | 1-10, 13-17, 20-23, 26,27 | |
| D,X | US - A - 4 772 541 (GOTTSCHALK) * Claims; table; abstract; example 1 * | 1,2,5-9,11-17,20-23,26, 27 | |
| X | EP - A2/A3 - 0 308 274 (THE MEAD CORPORATION) * Claims * | 1-10, 13-16 | TECHNICAL FIELDS SEARCHED (Int. Cl.5) |
| D,Y | EP - A2/A3 - 0 292 323 (THE MEAD CORPORATION) * Claims * | 1,18, 19,24, 25 | G 03 F<br>C 08 F |

The present search report has been drawn up for all claims

| Place of search | Date of completion of the search | Examiner |
|---|---|---|
| VIENNA | 29-10-1990 | SCHÄFER |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document